# EUROPEAN PATENT APPLICATION

(11) **EP 1 978 516 A1**
(43) Date of publication of application: **08.10.2008**
(21) Application number: 08013027.1
(22) Date of filing: 13.01.2006
(51) Int. Cl.: G11B 7/243, C23C 14/34

(54) **Recording film for use in optical information recording medium, optical information recording medium, and sputtering target**

(30) Priority: 07.02.2005 JP 2005030788; 08.12.2005 JP 2005355012
(62) Divisional of application: 06000736.6
(71) Applicant: Kabushiki Kaisha Kobe Seiko Sho, Chuo-ku Kobe-shi Hyogo 651-8585 (JP)
(72) Inventor: Tauchi, Yuki, Kobe-shi, Hyogo 651-2271 (JP); Nakai, Junichi, Kobe-shi, Hyogo 651-2271 (JP); Fujii, Hideo, Kobe-shi, Hyogo 651-2271 (JP); Ido, Tatewaki, Kobe-shi, Hyogo 651-2271 (JP)
(74) Representative: Müller-Boré & Partner Patentanwälte

(57) **Abstract**

There is provided a sputtering target for forming a recording film for use in an optical information recording medium, comprising an Al alloy containing at least one of Sn, Zn, and Mg totaling 5.0 to 60 at%.

## Description

The present invention belongs to a technical field concerning a recording film for use in an optical information recording medium, an optical information recording medium, and a sputtering target and, more particularly, it relates to a recording film for use in an optical information recording medium different from existent organic dyes to be used for writing once optical information recording media such as CD-R, DVD-R, once writing Blu-ray, writing once HD DVD, etc. and an optical information recording medium using such a recording film belonging to the technical field regarding the optical information recording medium.

Optical disks include several types and in view of the recording/reproducing principle they are generally classified into three types of read only, writing once type and rewritable types

Among them, the writing once type disk has a structure in which an azo or cyanine-type organic dye is coated as a recording layer on a transparent elastic substrate and a reflective layer comprising an A1 alloy or an Ag alloy is formed thereover.

In the writing once type disk, the reflectivity of a dye recording layer is changed by decomposition and denaturation of the portion by laser irradiation and signals are recorded. Since the decomposition and denaturation of the dye recording layer is irreversible change, the signals are recorded only for once in the writing once type disk, which is a difference from the rewritable disk capable of overwriting repetitively for an identical position.

In the writing once disk of the type using the dye, it is necessary to form a dye by using a spin coater in the course of manufacturing the disk and, accordingly, it involves problems that the control for the thickness of the dye recording layer is difficult, and formation of multi-layered structure is difficult and the productivity is low.

In view of the above, it has been proposed in recent years a new type disk of forming an inorganic thin film by a vacuum process. Regarding the inorganic type writing once film, it has been proposed, for example, a method of irreversibly changing the tissue by laser heating [WO98-09823 (Japanese Patent Application No. 10-512489)] using Te-O-Pd thin film, or a method of mixing a layer comprising Ge, Si, and Sn as a main ingredient and a layer comprising Cu, Al, Zn, and Ag as a main ingredient by heating (JP-A No. 2004-158145).

In view of the principle, while it is also possible to use phase change type disks using a so-called phase change material such as Ge-Sb-Te or Ag-In-Sb-Te as a writing once type disk, since they have a complicate structure comprising at least 4 to 5 layers of thin films, they have no advantage compared with existent dye type writing once type media in view of the cost or the productivity.

As described above, use of the dye recording layer involves a problem that the control for the thickness of the dye recording layer is difficult, the formation of the multilayer is difficult and the productivity is low. Further, in a case of using the existent inorganic type film as the recording film, it involves a problem in view of the durability (recording retainability), and has a problem, for example, that signal characteristics are degraded after a humidity resistance and heat resistance test.

The present invention has been achieved in view of the foregoing situation and it intends to provide a recording film for use in an optical information recording medium excellent in the productivity and in the durability (recording retainability), as well as an information recording medium.

In the system of melting an inorganic thin film itself by the heat of laser irradiation (laser heating) and physically forming apertures or changing the conformation thereby conducting recording (hereinafter referred to also as a laser heat melting recording system), the thin film corresponds to the recording film. The recording film by this system is extremely excellent in the productivity and also excellent in the durability (recording retainability). Accordingly, the foregoing object can be attained in a case where those exhibiting favorable performance as the recording film (recording film capable of conducting recording sufficiently) can be obtained by the system.

In view of the above, the present inventors have made an earnest study while taking notice on the laser heat melting recording system and, as a result, have found that a thin film material controlled to appropriate heat conductivity, light absorbing characteristics and melting temperature (melting point) can provide a favorable performance as the recording film for use in an optical information recording medium by the laser heat melting recording system, and have accomplished the invention. The foregoing object can be attained according to the invention.

The invention having thus been completed as described above and capable of attaining the foregoing object relates to a recording film for use in an optical information recording medium, and an optical information recording medium, as well as a sputtering target, which include recording films for use in an optical information recording medium according to 1st to 9th feature of the invention, optical information recording medium according to the 10th to 16th feature of the invention, and sputtering targets according to 17th to 25th feature of the inventions and they have the following constitutions.

That is, a recording film for use in an optical information recording medium in the first feature of the invention has a heat conductivity of 0.8 W/Kcm or less, a light absorptivity to a light at a wave length of from 0.3 µm to 1.0 µm of 15% or more and a melting temperature from 300 to 800°C (first feature of the invention).

A recording film for use in an optical information recording medium in the second feature of the invention is a recording film of the first feature, wherein the reflectivity is 20% or higher (second feature of the invention).

The recording film for use in an optical information recording medium in the third feature of the invention is a recording film of the first feature or the second feature, wherein the optical information recording medium comprises an Al alloy containing at least one of Sn, Zn, and Mg totaling 5.0 to 60 at% (third feature of the invention). The recording film for use in an optical information recording medium in the fourth feature of the invention is a recording film of the third feature, wherein the Al alloy contains at least one of In, Mn and Ni totaling 2.0 to 10.0 at% (fourth feature of the invention).

The recording film for use in an optical information recording medium in the fifth feature of the invention is a recording film of the third or fourth feature, wherein the Al alloy contains at least one of Nd and Y totaling 1.0 to 20.0 at% (fifth feature of the invention).

The recording film for use in an optical information recording medium in the 6th feature is a recording film of any one of the third to fifth features, wherein the Al alloy contains at least one of Cr, Ta, Ti, and Ni totaling 1.0 to 10.0 at% (6th feature of the invention).

The recording film for use in an optical information recording medium in the 7th features of the invention is a recording film of any one of the third to 6th features, wherein the A1 alloy contains at least one of Si and Ge totaling 1.0 to 15.0 at% (7th feature of the invention).

The recording film for use in an optical information recording medium in the 8th features of the invention is a recording film of the first or second feature, comprising an Ag alloy containing at least one of Sn, In, Bi, and Nd totaling 5 to 30 at% (8th feature of the invention).

The recording film for use in an optical information recording medium in the 9th feature of the invention is a recording film according to the first or the second feature, comprising the Ag alloy containing at least one of Sn, In, and Nd totaling 5 to 30 at % and containing at least one of Bi and Sb totaling 0.01 to 2.0 at% (9th feature of the invention).

The optical information recording medium in the 10th feature of the invention is a recording medium, in which a recording film and a protective film are formed successively on a substrate, and the recording film is a recording film for use in an optical information recording medium according to any one of first to 9th features (10th feature of the invention).

The optical information recording medium in the 11th feature of the invention is a recording medium in which a reflective film or a heat controlling film, a recording film, and a protective film are formed successively on a substrate, and the recording film comprises a recording film for use in an optical information recording medium according to any one of the first to 9th features.

The optical information recording medium in the 12th feature of the invention is a recording medium in which a reflective film or a heat controlling film, a dielectric film, a recording film, a dielectric film, and a protective film are formed successively on a substrate, and the recording film comprises the optical information recording medium according to any one of the first to 9th features (eleventh feature of the invention).

The optical information recording medium in the 13th feature of the invention is a recording medium according to the 11th or 12th feature, wherein the reflective film or heat controlling film comprises a Cu alloy (13th feature of the invention).

The optical information recording medium in the 14th feature of the invention is a recording medium of the 13th feature, wherein the Cu alloy contains at least one of Ti, Cr, Ta, Al, Mg, and Ni totaling 3.0 to 15.0 at% (14th feature of the invention).

The optical information recording medium in the 15th feature of the invention is a recording medium according to the 11th to 14th features, wherein the thickness of the reflective film or the heat controlling film is from 20 to 150 nm (15th feature of the invention).

The optical information recording medium in the 16th feature of the invention is a recording medium according to any one of 10th to 15th features, wherein the thickness of the recording film is from 5 to 50 nm (16th feature of the invention).

A sputtering target for forming a recording film for use in an optical information recording medium of the 17th feature is a sputtering target comprising an Al alloy containing at least one of Sn, Zn, and Mg totaling 5.0 to 60 at% (17th feature of the invention). A sputtering target in the 18th feature of the invention is a sputtering target according to 17th feature, wherein the Al alloy contains at least one of In, Mn and Ni totaling 2.0 to 10.0 at% (18th feature of the invention).

A sputtering target in the 19th feature of the invention is a sputtering target according to 17th or 18th feature, wherein the Al alloy contains at least one of Nd and Y totaling 1.0 to 20.0 at% (19th feature of the invention).

A sputtering target in the 20th feature of the invention is a sputtering target according to any one of 17th to 19th feature, wherein the Al alloy contains at least one of Cr, Ta, Ti, and Ni totaling 1.0 to 10.0 at% (20th feature of the invention).

A sputtering target in the 21st feature of the invention is a sputtering target according to any one of 17th to 20th feature, wherein the Al alloy contains at least one of Si and Ge totaling 1.0 to 15.0 at% (21st feature of the invention).

A sputtering target for forming a recording film for use in an optical information recording medium in the 22nd feature of the invention is a sputtering target comprising an Ag alloy containing at least one of Sn, In, and Nd totaling 5 to 30 at% (22nd feature of the invention).

A sputtering target in the 23rd feature of the invention is a sputtering target for forming a recording film for use in an optical information recording medium, comprising an Ag alloy containing Bi of 10 to 60 at% (23rd feature of the invention).

A sputtering target in the 24th feature of the invention is a sputtering target of the 22nd or 23rd feature, wherein the Ag alloy contains Sb of 0.01 to 2.0 at% (24th feature of the invention).

A sputtering target in the 25th feature of the invention is a sputtering target according to 22nd feature wherein the Ag alloy contains Bi of 0.05 to 5 at% (25th feature of the invention).

The recording film for use in an optical information recording medium according to the invention is excellent in the productivity and also excellent in the durability (recording retainability). The optical information recording medium according to the invention uses such a recording film as the recording film therefor. Therefore, according to the invention, a recording film for use in an optical information recording medium of excellent productivity and durability can be obtained and also an optical information recording medium having such a recording film can be obtained.

Embodiments of the present invention will be described in detail based on the following figures, wherein:
Fig. 1 is a schematic view showing an example of an optical information recording medium according to a ninth feature of the invention of the invention;
Fig. 2 is a schematic view showing an example of an optical information recording medium according to a tenth feature of the invention of the invention; and
Fig. 3 is a schematic view showing an example of an optical information recording medium according to an eleventh feature of the invention of the invention.

In the system of melting an inorganic thin film itself by the heat of laser irradiation (laser heating) and physically forming apertures or changing the conformation thereby conducting recording (laser heat melting recording system), the following characteristics are required for the film in order that the film can provide favorable performance as the recording film.

That is, since it is necessary for recording at high sensitivity to a laser light, the film (recording film) is desired to efficiently absorb heat by the laser heating and the film can be melted efficiently only for a desired region. Accordingly, it is required that the heat conductivity is low, the light absorptivity is high, and the melting temperature is appropriate.

For this purpose, the recording film for use in an optical information recording medium according to the invention (hereinafter also referred to as a recording film) is defined to have a heat conductivity of 0.8 W/Kcm or lower. In a case where the heat conductivity of the recording film exceeds 0.8 W/Kcm, after the recording film absorbs an incident light from the laser, the heat diffuses to the periphery and the temperature for the laser irradiated portions does not rise sufficiently and not reach melting. In this case, while the temperature can be elevated by increasing the laser output, the recording mark enlarges exceeding a predetermined range because of the diffusion heat.

The light absorptivity is defined as 15% or higher. The wave length of the light is that of the laser wave length used for conducting writing and reading and a wavelength usually at about 400 nm to 850 nm is used. Accordingly, it is defined that the light absorptivity is 15% or more relative to a light at a wave length from 0.3 µm to 1.0 µm. In a case where the light absorptivity is less than 15%, because the laser light incident to the recording film is reflected or transmitted the heat is not absorbed and does not melt the film.

The melting temperature (melting point) is defined as from 300 to 800°C. In a case where, the melting temperature is lower than 300°C, it is melted as far as the peripheral portion by the incident light of the laser, which enlarges the recording mark. On the other hand, in a case where the melting temperature exceeds 800°C, recording can not be attained easily.

As described above, since the recording film according to the invention (recording film for use in an optical information recording medium) is defined to have the heat conductivity of 0.8 W/Kcm or less, the light absorptivity to a light at a wave length of 0.3 µm to 1.0 µm of 15% or more, as well as the melting temperature of 300 to 800°C, it provides a favorable performance as the recording film by the laser heat melting recording system. That is, in the laser heat melting recording system, when the recording film according to the invention is used as the recording film, the recording film can efficiently absorb the heat by the laser heating and can be melted efficiently only at a desired range of the recording film and, accordingly, it can provide a satisfactory performance as the recording film (sufficient recording is possible).

The recording film according to the invention is used as the recording film in the laser heat melting recording system and can provide a satisfactory performance as described above. The recording film obtained by the system is excellent in the productivity and also excellent in the durability (recording retainability) as described above. That is, since the recording film used in the system is extremely excellent in the productivity compared with the existent case of the dye recording layer, due to extremely easy control for the film thickness and easy formation of multi-layered structure. Further, since the recording film in this system does not require the complicate structure as in the case of using the phase change material such as Ge-Sb-Te, it is extremely excellent in the productivity when compared with the case of using such a phase change material. Further, in the recording film of this system, since recording is conducted by melting the film by the heat of laser irradiation (laser heating) and physically forming apertures or changing the conformation, the recording signal characteristics are less degraded, the recording store stability is high and the durability is excellent when compared with the case of conducting recording, for example, by irreversible change of the tissue by laser heating as in the case of the existent inorganic thin film (for example in Japanese Patent Application No. 10-512489, JP-A No. 2004-153145).

Accordingly, the recording film according to the invention (recording film for use in an optical information recording medium) not only provides satisfactory performance as the recording film by the laser heat melting recording system (sufficient recording is possible) but also is excellent in the productivity and excellent in the durability (recording retainability). That is, according to the invention, it is possible to obtain a recording film for use in an optical information recording medium capable of providing a satisfactory function as the recording film by the laser heat melting recording system and is also excellent in the durability, with a good productivity.

Further, the recording film according to the invention also has an advantage capable of having the function as a reflective film due to the structure of a medium and it is further useful in this regard. In a case where the function as the reflective film is also necessary, it is preferred that the light reflectivity of the film is 20% or higher (second feature of the invention).

The recording film according to the invention, in view of the composition thereof, can include specifically those comprising an Al alloy containing one or more of Zn, and Mg totaling 5.0 to 60 at% and those comprising an Ag alloy containing one or more of Sn, In, Bi, and Nd totaling 5 to 30 at%. In each of the alloys, elements of greatly decreasing the heat conductivity and improving the light absorptivity without greatly increasing the melting temperature of Al or Ag as the main ingredient (liquidous temperature) are added. While the heat conductivity is lowered also by adding, for example, transition metals, etc. among the elements described in W098-09823 described above, the melting temperature increases greatly thereby making recording difficult.

In a case where the addition amount for one or more of Sn, Zn, Mg and Cu according to the third feature of the invention is defined as less than 5.0 at% in total, the effect of decreasing the heat conductivity is small and the effect of improving the light absorptivity is small. On the other hand, in a case where the addition of amount exceeds 60 at% in total, the melting temperature increases remarkably and the characteristic as the recording film can no more be provided and the reflectivity may also be decreased possibly in the type used also as the reflective film. In a case where the addition amount for one or more of Sn, In, Bi, and Nd according to the 8th feature of the invention is less than 5 at% in total, the effect of decreasing the heat conductivity is small and the effect of improving the light absorptivity is small. On the other hand, in a case where the addition amount exceeds 30 at% in total, the melting temperature increases remarkably, the characteristic as the recording film can no more be provided, and the reflectivity may also be lowered possibly in the type to be used also as the reflective film.

In a case where one or more of In, Mn and Ni totaling 2.0 to 10.0 at% is included further in the Al alloy according to the third feature of the invention, since In, Mn and Ni are elements of more improving the light absorptivity. It is possible to decrease the laser power for the recording, for example lower than 10mW. In a case where the addition amount of one or more of In, Mn and Ni is less than 2.0 at% in total, such effect can not be obtained sufficiently. On the other hand, in a case where it exceeds 10.0 at%, the reflectivity may possibly be lowered possibly in a type to be used also as the reflective film.

In a case where one or more of Nd and Y totaling 1.0 to 20.0 at% is included further in the Al alloy according to the third or fourth feature of the invention, since Nd and Y are elements of greatly decreasing the heat conductivity and improving the light absorptivity without greatly increasing the melting temperature of Al, it is possible to decrease the heat conductivity further and improve the light absorptivity further without greatly increasing the melting temperature. In a case where the addition amount of one or more of Nd and Y is less than 1.0 at% in total, such effect can not be obtained sufficiently. On the other hand, in a case where it exceeds 20.0 at%, the melting temperature increases remarkably, the characteristic as the recording film can no more be provided, and the reflectivity may possibly be lowered possibly in a type to be used also as the reflective film.

In a case where one or more of Cr, Ta, Ti, and Ni totaling 1.0 to 10.0 at% is further included in the Al alloy according to the third to 5th feature of the inventions, the corrosion resistance can be improved remarkably and it is possible to further lower the heat conductivity and improve the light absorptivity. Since the recording film is usually used at a thickness of about five to several tens nm, excellent corrosion resistance is extremely useful. In a case where the addition amount of one or more of Cr, Ta, Ti and Ni is less than 1.0 at% in total, such an effect of improving the corrosion resistance can not be provided sufficiently. In a case where it exceeds 10,0 at%, the melting temperature increases excessively, the characteristic as the recording film can no more be provided and the reflectivity may also be lowered possibly.

Further, in a case of further including one or more of Si and Ge totalling 1.0 to 15.0 at% in the Al alloy according to the third to 6th feature of the inventions, the melting temperature can be lowered further. Further, the corrosion resistance can be improved further. In a case where the addition amount of one or more of Si and Ge is less than 1.0 at% in total, the effect of lowering the melting temperature, etc. can not be obtained sufficiently. On the other hand, in a case where the addition amount exceeds 15.0 at% in total, although degradation which gives rise to a problem for the film characteristic is not particularly caused, it is preferably 15.0 at% or less in view of the worry for the lowering of the resistance in a case where it is to be used also as the reflective film, or in view of easy manufacture of a sputtering target for forming the film. Further, addition of Si, Ge has no effect of decreasing the heat conductivity.

A recording film comprising an Ag alloy containing at least one of Sn, In, and Nd totaling 5 to 30 at% and containing at least one of Bi and Sb totaling 0.01 to 2.0 at% can provide the same function and effect as those in the recording film comprising the Ag alloy according to the 8th feature of the invention, as well as has larger degree of suppression for the lowering of the reflectivity compared with the recording film comprising the Ag alloy according to the seventh feature of the invention and it is useful in a case of use also as the reflective film. That is, since the Ag alloy according to the 9th feature of the invention contains one or more of Sn, In and Nd totaling 5 to 30 at%, it can provide the same function and effect as those in the Ag alloy according to the 8th feature of the invention. Since the lowering of the reflectivity after a moisture and heat resistant test can be suppressed by incorporation of one or more of Bi and Sb, it is useful in the case of use also as the reflective film. In a case where the addition amount of one or more of Bi and Sb is less than 0.01 at% in total, the effect of suppressing the lowering of the reflectivity is small and, on the other hand, in a case where the addition amount exceeds 2.0 at% in total, lowering of the reflectivity is increased conversely. The function due to the amount of Sn, In, and Nd is identical with the case of the amount of Sn, In, and Nd according to the 8th feature of the invention.

The optical information recording medium according to the invention is an optical information recording medium in which the recording film and the protective film are formed successively over the substrate, and the recording film comprises the recording film as described in any one of the first to the 9thfeatures of the invention. Further, this is an optical information recording medium in which the reflective film or the heat conditioning film, the recording film, and the protective film are formed successively over the substrate and the reflective film comprises a recording film according to any of the first to the 9th feature of the inventions. Further, this is an optical information recording medium in which the reflective film or the heat conditioning film, the dielectric film, the recording film, the dielectric film, and the protective film are formed successively over the substrate, and the recording film comprises the recording film according to any one of the first to the 9th features of the invention.

As can be seen from the foregoings, the recording film according to the first to the 9th feature of the inventions (recording film of the invention) can provide a favorable performance as the recording film in the laser heat melting recording system (sufficient recording is possible) but also is excellent in the productivity and excellent in the durability (recording retainability). In the optical information recording medium according to the invention, any of the recording films according to the first to the 9th feature of the inventions (recording film according to the invention) is used as the recording film therefore.

Accordingly, in the optical information recording medium according to the invention not only the recording film can provide a favorable performance to enable sufficient recording, but also the medium can be obtained at a good productivity and it is excellent in the durability of the recording film (recording retainability).

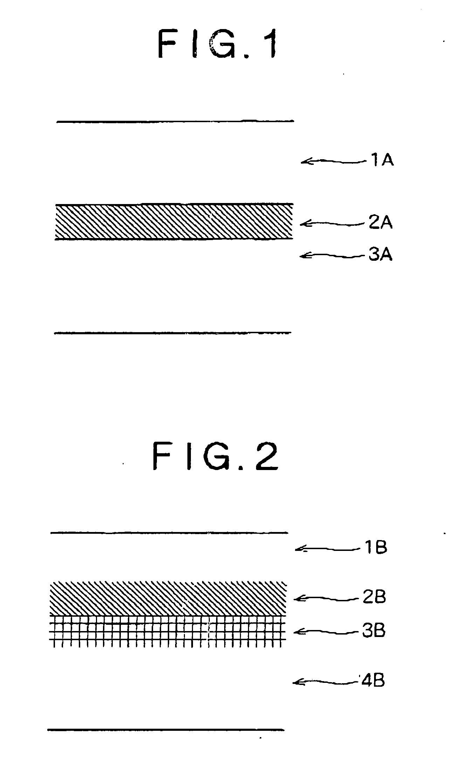

An example of the optical information recording medium according to the 10th feature of the invention is shown in Fig. 1 (schematic cross sectional view). A substrate 3A, a recording film (hereinafter also referred to as a recording layer) 2A, and a protective film hereinafter also referred to as a protective layer) 1A are provided from the side of the substrate.

In the optical information recording medium according to the 10th feature of the invention, the thickness for the recording film is preferably from 5 to 50 nm. In view of the increase in the transmission light, decrease in the reflectivity and decrease in the heat capacity due to reduction of the film thickness, it is more preferred that the thickness for the recording film is 10 nm or more and 40 nm or less.

In a case of making a reading laser light falling from the side of the protective layer and conducting reading by a reflection light, the protective layer is preferably made of a transparent resin and such transparent resin includes, for example, polycarbonate, acryl resin, epoxy resin, and urethane resin. The polycarbonate resin is particularly preferred in view of the fabricability and the optical characteristics. In a case of using the polycarbonate resin as the protective layer, while a polycarbonate is used at 0.6 nm thickness for DVD and at 1.2 nm thickness for CD, this is not particularly limited and, in view of the moldability or the strength, it is preferably 0.05 mm or more and 1.5 mm or less. As the substrate, a transparent resin such as a polycarbonate resin or acryl resin is preferred. The transparent protective layer may be provided by two layers.

In the optical information recording medium illustrated in Fig. 1, since the recording film also has a function as a reflective film, it is desired that also the reflectivity is controlled appropriately.

An example of an optical information recording medium according to the 11th feature cf the invention is shown in Fig. 2 (schematic cross sectional view). A substrate 4B, a reflective film or heat conditioning film 3B, a recording layer 2B, and a protective layer 1B are provided from the side of the substrate.

In the optical information recording medium illustrated in Fig. 1, since the recording layer is put between the substrate and the protective film, heat can not be dissipated to bring about a worry of increasing the damage to the substrate or making it difficult for sharp recording since heat tends to be diffused on the film surface. On the contrary, in the optical information recording medium according to the tenth feature of the invention, the diffusion of heat in the direction of the film surface is suppressed by the provision of the heat controlling layer and damages to the substrate due to excess heat are suppressed. Further, in a case where the reflectivity is insufficient upon generation merely by the recording film, a reflective layer is disposed in order to improve the re-productivity.

In the optical information recording medium according to the 11th feature of the invention, in a case of providing the heat controlling layer, it is preferred that the heat conductivity of the heat controlling layer is equal with or less than that of the recording film. This is because the heat is dissipated excessively upon melting the recording film in a case where the heat conductivity of the heat controlling layer is high. Further, it is desirable that the corrosion resistance is favorable.

The constituent material for the reflective film or the heat controlling film in the optical information recording medium according to the 11th feature of the invention includes, for example, alloys comprising Ag, Al, Cu, Au, etc., and the use of Cu alloy is recommended. As the Cu alloy, those containing one or more of Ti, Cr, Ta, Al, Mg, and Ni totaling 3.0 to 15.0 at% are preferred with a view point of the heat conductivity and with the view point of the corrosion resistance. The thickness for the reflective film or the heat control film is preferable 20 to 150 nm. The film thickness is particularly preferably from 10 nm to 50 nm with a view point of light transmittance and heat capacity.

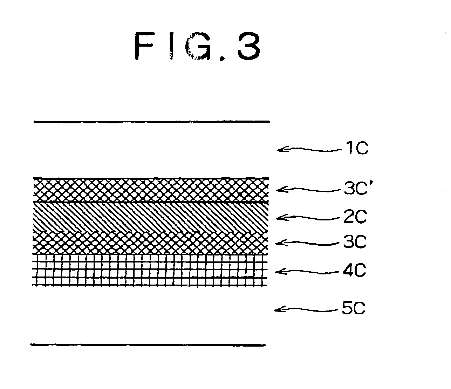

An example of the optical information recording medium according to the 12th feature of the invention is shown in Fig. 3 (schematic cross sectional view). Dielectric films 3C, 3C are disposed above and below the recording layer 2C. Then, a reflective film (hereinafter also referred to as a reflective layer) or a heat control film (hereinafter also referred to as heat controlling layer) 4C is provided below the dielectric film 3C on the side opposite to the incident surface for the laser. That is, the substrate 5C, the reflective film or heat control film 4C, the dielectric film 3C, the recording layer 2C, the dielectric film 3C, and the protective layer 1C are provided from the side of the substrate. The dielectric films 3C, 3C are inserted above and below the recording layer 2C in order to suppress the effect of heat by the melting of the recording layer 2C on the substrate 5C or other layers.

The constituent material for the dielectric film (dielectric layer) can include, for example, ZnS-SiO₂, ZnS, SiO₂, SiN, SiC, etc. ZnS-SiO₂ is particularly preferred with a view point of the optical characteristics and the small heat expansion coefficient. The thickness for the dielectric film is preferably 1 nm or more and 200 nm or less. In a case where it is less than 1 nm, no sufficient effect as the dielectric layer can not provided and, on the other hand, in a case where it exceeds 200 nm, this distorts the substrate by the film stress to lose the smoothness of the substrate.

Also in the optical information recording medium according to the 11th to 12nth feature of the inventions and optical information recording medium according to 13th to 15th feature of the inventions, the thickness of the recording film is preferably from 5 to 50 nm in the same meaning as in the case of the optical information recording medium according to the 10th feature of the invention. The thickness of the recording film is more preferably 10 nm or more and 40 nm or less in view of increase in the transmission light, decrease in the reflectivity and decrease in the heat capacity due to reduction of the film thickness.

For obtaining the recording film for use in the optical information recording medium according to the third to 9th features of the invention, it is preferred to adopt a sputtering method and, in this case, use of the sputtering target according to 17th to 25th features of the invention is recommended as the sputtering target.

When the sputtering target according to the 17th feature of the invention is used, the recording film according to the third feature of the invention can be formed. In a case of using the sputtering target according to the 18th feature of the invention, the recording film according to the fourth of the invention can be formed. In a case of using the sputtering target according to the 19th feature of the invention, the recording film according to the fifth feature of the invention can be formed. In a case of using the sputtering target according to the 20th feature of the invention, the recording film according to the sixth feature of the invention can be formed.
In a case of using the sputtering target according to the 21st feature of the invention, the recording film according to the 7th feature of the invention can be formed.

In a case of using the sputtering target according to the 22nd feature of the invention, or the sputtering target according to the 23rd feature of the invention, the recording film according to the 8th feature of the invention can be formed. In a case of using the sputtering target according to the 24th feature of the invention and the sputtering target according to the 25th feature of the invention, the recording film according to the 9th feature of the invention can be formed.

In a case of Bi, the content is different between the sputtering target (hereinafter also referred to as a target) and the formed recording film by sputtering. This is because the composition in the target and the composition in the formed film are not identical in the case of Bi. For the elements other than Bi, the composition in the target and the composition in the formed film are identical or substantially identical. However, it is considered that since vapor pressure of Bi is low, the yield of Bi in the target to the film upon deposition of the film by sputtering is lowered.

### [Example]

The examples of the present invention and comparative examples are to be described. The invention is not restricted to the examples and they can be practiced with appropriate modification within a range capable of conforming the gist of the invention and any of them is contained within the technical scope of the invention.

### [Example 1]

By thermal analysis simulation, the highest attainable temperature was calculated. In this case, a recording film and a protective film were provided successively on a polycarbonate substrate (substrate comprising polycarbonate) and the thickness of the recording film was 20 nm. The constituent material of the recording film (recording material) was an Al alloy and the light absorptivity of the recording film was set to 30%. The laser spot was set to 0.3 µm diameter. The laser irradiation time was 15 ns. The heat conductivity of the recording film was changed as a parameter.

The result of the calculation, that is, the highest attainable temperature determined based on the calculation (highest attainable temperature at the center of the laser spot) is shown in Table 1. Further, the highest attainable temperature ratio between the central portion of the laser spot and a portion spaced apart by 0.3 µm from the central portion [the highest attainable temperature determined by the calculation (highest attainable temperature at the central portion of the laser spot)/ highest attainable temperature at a position spaced by 0.3 µm from the central portion of the laser spot] was determined, which was shown as a heat interference ratio in table 1.

As apparent from Table 1, in a case where the heat conductivity of the recording film exceeds 0.8 W/Kcm, it can be seen that the heat diffusion is rapid, the temperature does not increase sufficiently and it does not reach as far as the vicinity of the melting temperature of the recording film. This represents that the heat interference is large and a fine mark is difficult to be formed in this case.

### [Example 2]

The heat analysis simulation was conducted to calculate the highest attainable temperature. In this case, a recording film and a protective film are present in this order above a polycarbonate substrate (substrate comprising polycarbonate) and the thickness of the recording film was 20 nm. The constituent material for the recording film (recording material) was Al alloy and the heat conductivity of the recording film was 0.3 W/Kcm. The laser spot was 0,3 µm diameter. The laser irradiation time was 15 ns. The light absorptivity of the recording film was changed as the parameter.

The result of the calculation, that is, the highest attainable temperature determined by the calculation is shown in Table 2. As apparent from Table 2, it can be seen that the recording temperature does not increase sufficiently and not reach as far as the vicinity of the melting temperature in a case where the light absorptivity of the recording film is less than 15%.

### [Example 3]

A recording film comprising an Al alloy of 20 nm thickness was formed on a polycarbonate resin substrate (substrate comprising polycarbonate resin) of 0.6 mm thickness and 120 mm diameter.

In this case, the composition of the recording film constituent material (Al alloy), etc. were controlled such that the heat conductivity of the recording film was from 0.05 to 1.0 W/Kcm. The recording film was formed by sputtering by using a sputtering target comprising an Al alloy. The composition of the recording film was measured by ICP mass analysis.

The heat conductivity of the recording film was determined being converted from the specific resistivity of the recording film (thin film) according to the Wiedermann Franz's rule. For measuring the specific resistivity of the recording film (thin film), a thin film on a glass substrate of 100 nm thickness was used, the resistivity was measured by a 4-probe electrical resistance measuring device, and the sheet resistance was determined to calculate the specific resistivity.

The reflectivity of the recording film was determined by measuring the absolute reflectivity of the recording layer formed on the polycarbonate resin substrate by using a visible-UV spectrophotometer (V-570 manufactured by JASCO Co.).

The light absorptivity (%) of the recording film was calculated by using the equation: 100-[reflectivity (%) + transmittance (%)]. The transmittance (%) was determined by measuring the sample for which the reflectivity was measured by using the visible lay-UV spectrophotometer described above.

The melting temperature of the recording film was measured by peeling an Al alley film deposited to 1 µm thickness from the substrate and collected in an amount of about 5 mg by using a differential thermal analyzer and it was calculated as a mean value of the temperature for starting melting and the temperature at the end of melting.

The recording mark was formed (recorded) to the thus formed recording film. Upon forming the recording mark, the laser power at the film surface was 10 mW and the speed was 5 m/s. A semiconductor laser at a wave length of 405 nm was used as a light source and the laser spot size was set to 0.8 µm diameter. The laser light was irradiated on the side of the recording film.

The shape of the mark after the recording (formation of the recording mark) was observed by an optical microscope and the ratio of the mark forming area (melting are) (S₂) relative to the laser irradiation area (S₁) was determined by the calculation based on image processing analysis. It was evaluated in view of the area ratio as failure in a case where the area ratio [(S₂*l*S₁] × 100] was less than 20%, as excellent in a case where it is from 20 to 90% (20% or more and 90% or less) and as fair (inferior to excellent but superior to failure, being within an allowable range) in a case where it exceeds 90%, and they were defined as the index for the recording performance.

The results are shown in Table 3. As apparent from Table 3, melting points of the recording films are within the range from 300 to 800°C for any of the recording films, they show no significant difference between each of the recording films and were at a substantially identical level. It can be seen that the area ratio of the index as the recording performance [(S₂/S₁) × 100] was from 20 to 90% (excellent) and good recording marks could be formed in the recording films with the heat conductivity of 0.8 W/Kcm or less and the light absorptivity was 15% or more among the recording films. The reflectivity (light reflectivity) is as shown in Table 3. This is the initial reflectivity at a wave length of 405 nm.

### [Example 4]

(1) An Al film or Al alloy film of 20 nm thickness was formed on a polycarbonate substrate of 0.6 mm thickness and 120 mm diameter by sputtering. As the Al alloy film, Al-Sn alloy film, Al-Mg alloy film, or Al-Zn alloy film was formed. The amount of alloying elements (Sn content, Mg content, and Zn content) was changed.
   For each of the Al film and the Al alloy films, the heat conductivity, the reflectivity, the light absorptivity, and the melting temperature of the film were determined by the same manner as that in the case of Example 3. Further, recording marks were formed (recorded) to each of the films by the same method as that in the case of Example 3, the ratio of the mark forming area (S₂) relative to the laser irradiation area (S₁) was determined as an area ratio [(S₂/S₁) × 100] and this was used as an index of the recording performance. The evaluation standard for the area ratio was identical with that in Example 3. That is, it was evaluated in view of the area ratio as failure in a case where it was less than 20%, excellent in a case where it was from 20 to 90% (20% or more and 90% or less) and fair in a case where it exceeded 90% (allowable range though inferior to excellent).
   Further, for each of the Al film and the Al alloy films, after retaining them in an atmospheric air at a temperature of 80°C and at a humidity of 85%, the reflectivity (reflectivity at a wavelength of 405 nm) was measured and corrosion resistance was evaluated by the lowering amount of the reflectivity at the wavelength of 405 nm before and after 95 hr's retention.
   The result is shown in Table 4. As apparent from Table 4, each of Al-Sn alloy film, Al-Mg alloy film, and Al-Zn alloy film had extremely lower heat conductivity compared with the A1 film and melting temperature equal with or lower than those in the case of the Al film and, accordingly, it can be seen that the heat conductivity can be decreased without increasing the melting temperature by the addition of Sn, Mg, or Zn to Al. Further, in a case where the addition amount (content) of the elements was 5 at% or more, the area ratio as the index of the recording performance [(S₂/S₁) × 100] was excellent (20 to 90%) or fair (90% or more) with most of them being excellent and a portion of them being fair. In a case of 5 to 60 at%, it was excellent (20 to 90%) for all of the cases and favorable recording marks were formed. The reflectivity (light reflectivity) is as shown in Table 4. This is the initial reflectivity at a wavelength of 405 nm.
(2) An Al film or Al alloy film of 20 nm thickness was formed on a polycarbonate substrate of 0.6 mm thickness and 120 mm diameter by sputtering. As the Al alloy film, Al-Sn-In alloy film, Al-Sn-Mn alloy film, or Al-Sn-Ni alloy film was formed.

For each of the Al film and the Al alloy films, the heat conductivity, the reflectivity, the light absorptivity, and the melting temperature of the film were determined by the same manner as that in the case of Example 3. Further, recording marks were formed (recorded) to each of the films by the same method as that in the case of Example 3, the ratio of the mark forming area (S₂) relative to the laser irradiation area (S₁) was determined as an area ratio [(S_{2/}S₁) × 100] and this was used as an index of the recording performance. The evaluation standard for the area ratio was identical with that in Example 3. That is, it was evaluated in view of the area ratio as failure in a case where it was less than 20%, excellent in a case where it was from 20 to 90% (20% or more and 90% or less) and fair in a case where it exceeded 90% (allowable range though inferior to excellent).

Further, for each of the Al film and the Al alloy films, after retaining them in an atmospheric air at a temperature of 80°C and at a humidity of 85%, the reflectivity (reflectivity at a wavelength of 405 nm) was measured and corrosion resistance was evaluated by the lowering amount of the reflectivity at the wavelength of 405 nm before and after 95 hr's retention. The result is shown in Table 4.

### [Example 5]

An Al film or Al alloy film of 20 nm thickness was formed on a polycarbonate substrate of 0.6 mm thickness and 120 mm diameter by sputtering. As the Al alloy film, Al-Sn alloy film, Al-Sn-Nd alloy film, or Al-Sn-Y alloy film was formed. The Nd content in the Al-Sn-Nd alloy film was changed.

For each of the Al film and the Al alloy films, the heat conductivity, the reflectivity, the light absorptivity, and the melting temperature of the film were determined by the same manner as that in the case of Example 3. Further, recording marks were formed (recorded) to each of the films by the same method as that in the case of Example 3, the ratio of the mark forming area (S₂) relative to the laser irradiation area (S₁) was determined as an area ratio [(S₂/S₁) × 100] and this was used as an index of the recording performance. The evaluation standard for the area ratio was identical with that in Example 3. That is, it was evaluated in view of the area ratio as failure in a case where it was less than 20%, excellent in a case where it was from 20 to 90% (20% or more and 90% or less) and fair in a case where it exceeded 90% (allowable range though inferior to excellent).

The result is shown in Table 5. As apparent from Table 5, Al-Sn (30 at%)-Nd(1.0 to 30 at%) alloy film, and Al-Sn (30 at%)-Y(10 at%) alloy film had lower heat conductivity compared with Al-Sn (30 at%) alloy film and, among them, Al-Sn(30 at%)-Nd(1.0 to 20 at%) alloy film, and Al-Sn(30 at%)-Y(10 at%) alloy film had the melting temperature equal with that in the case of Al-Sn(30 at%) alloy film, and, accordingly, it can be seen that the heat conductivity can be decreased without increasing the melting temperature by further adding Nd or Y by an amount from 1.0 to 20 at% to the Al-Sn alloy. Further, it can be seen that Al-Sn alloy with addition of Nd or Y in an amount of 1.0 to 20 at% had an area ratio [(S₂/S₁) × 100] as the index of the recording performance being evaluated as excellent (20 to 90%) in which good recording mark could be formed. Al-Sn(30 at%)-Nd(0.5 at%) alloy film had the area ratio [(S₂/S₁) × 100] as the index for recording performance being evaluated as excellent but the degree of lowering the heat conductivity was small. Al-Sn(30 at%)-Nd(30 at%) alloy film had an excessively high melting temperature and the area ratio [(S₂/S₁) × 100] as the index for recording performance was evaluated as failure (less than 20%) showing poor recording performance. Accordingly, it can be seen that the addition amount of Nd or Y to the Al-Sn alloy is preferably from 1.0 to 20 at%. The reflectivity (light reflectivity) is as shown in Table 5. This is the initial reflectivity at the wavelength of 405 nm.

### [Example 6]

An Al film or Al alloy film of 20 nm thickness was formed on a polycarbonate substrate of 0.6 mm thickness and 120 mm diameter by sputtering. As the Al alloy film, Al-Sn alloy film, Al-Sn-Nd-Ta alloy film, Al-Sn-Nd-Ti alloy film, or Al-Sn-Nd-Cr alloy film was formed. The Ta content in the Al-Sn-Nd-Ta alloy film was changed.

For each of the Al film and the Al alloy films, the heat conductivity, the light absorptivity, the melting temperature, and the reflectivity (initial reflectivity at a wavelength 405 nm) of the film were determined by the same manner as that in the case of Example 3. Further, recording marks were formed (recorded) to each of the films by the same method as that in the case of Example 3, the ratio of the mark forming area (S₂) relative to the laser irradiation area (S₁) was determined as an area ratio [(S₂/S₁) × 100] and this was used as an index of the recording performance. The evaluation standard for the area ratio was identical with that in Example 3. That is, it was evaluated in view of the area ratio as failure in a case where it was less than 20%, excellent in a case where it was from 20 to 90% (20% or more and 90% or less) and fair in a case where it exceeded 90% (allowable range though inferior to excellent).

For each of the A1 film and the Al alloy films, after retaining them in an atmospheric air at a temperature of 80°C and at a humidity of 85%, the reflectivity (reflectivity at a wavelength of 405 nm) was measured and the lowering amount of the reflectivity at the wavelength of 405 nm before and after 95 hr's retention was determined.

The results are shown in Table 6. As apparent from Table 6, Al-Sn(30 at%)-Nd(5.0 at%)-Ta(1.0 to 15 at%) alloy film, Al-Sn (30 at%)-Nd(5.0 at%)-Ti(2.0 at%) alloy film, and Al-Sn(30 at%)-Nd(5.0 at%)-Cr(2.0 at%) alloy film were excellent in the corrosion resistance, had less lowering amount of the reflectivity and, accordingly, it can be seen that the corrosion resistance can be improved and the lowering of the reflectivity can be suppressed by addition of Ta, Ti, or Cr with an amount of 1.0 at% or more. The degree of suppressing lowering of the reflectivity was small in Al-Sn(30 at%)-Nd(5.0 at%)-Ta(0.5 at%) alloy film. In Al-Sn(30 at%) -Nd (5.0 at%)-Ta(15 at%) alloy film, the melting temperature was excessively high and the area ratio [(S₂/S₁) × 100] as the index of the recording performance is evaluated as failure (less than 20%) and the recording performance was poor. Accordingly, it can be seen that the addition amount of Ta, Ti, or Cr is preferably from 1.0 to 10.0 at%.

### [Example 7]

An Al film or Al alloy film of 20 nm thickness was formed on a polycarbonate substrate of 0.6 mm thickness and 120 mm diameter by sputtering. As the Al alloy film, Al-Sn-Nd-Ta alloy film, Al-Sn-Nd-Ta-Si alloy film, or Al-Sn-Nd-Ta-Ge alloy film was formed. The Si content in the Al-Sn-Nd-Ta-Si alloy film was changed.

For each of the Al film and the Al alloy films, the heat conductivity, the light absorptivity, the melting temperature, and the reflectivity (initial reflectivity at a wavelength 405 nm) of the film were determined by the same manner as that in the case of Example 3. Further, recording marks were formed (recorded) to each of the films by the same method as that in the case of Example 3, the ratio of the mark forming area (S₂) relative to the laser irradiation area (S₁) was determined as an area ratio [(S₂/S₁) × 100] and this was used as an index of the recording performance. The evaluation standard for the area ratio was identical with that in Example 3. That is, it was evaluated in view of the area ratio as failure in a case where it was less than 20%, excellent in a case where it was from 20 to 90% (20% or more and 90% or less) and fair in a case where it exceeded 90% (allowable range though inferior to excellent).

For the Al film and the Al alloy films, an evaluation test for corrosion resistance was conducted. The test was conducted by a method of dipping a film into an aqueous 5% NaCl solution at 35°C to measure anode polarization, determining the pitting generation potential (potential corresponding to current density at 10 µA/cm²) therefrom, and evaluating the corrosion resistance based thereon.

The result is shown in Table 7. As apparent from Table 7, Al-Sn(30 at%)-Nd(2.0 at%)-Ta(1.0 at%)-Si(1.0 to 15 at%) alloy film and Al-Sn(30 at%)-Nd(2.0 at%)-Ta(1.0 at%)-Ge(15.0 at%) alloy film had a noble pitting corrosion generation potential and were excellent in the pitting corrosion resistance and, accordingly, it can be seen that the pitting corrosion resistance can be improved and, thus, lowering of the reflectivity can be suppressed by adding Si and Ge in an amount from 1-0 to 15.0 at%. In a case where the addition amount of Si or Ge is less than 1.0 at%, such an effect is small and, in a case where it exceeds 15.0 at%, the melting temperature increases remarkably and the recording performance was poor. Accordingly, it can be seen that the addition amount of Si or Ge is preferably from 1.0 to 15.0 at%.

### [Example 8]

An Ag film or Ag alloy film of 20 nm thickness was formed on a polycarbonate substrate of 0.6 mm thickness and 120 mm diameter by sputtering. As the Ag alloy film, Ag-Sn alloy film, Ag-In alloy film, Ag-Nd alloy film, Ag-Bi alloy film, or Ag-Sn-Bi alloy film was formed. The Sn content in the Ag-Sn alloy film and the Bi content in the Ag-Sn-Bi alloy film were changed.

For each of the Ag film and the Ag alloy films, the heat conductivity, the light absorptivity , the melting temperature, and the reflectivity (initial reflectivity at wavelength 405 nm) of the film were determined by the same manner as that in the case of Example 3. Further, recording marks were formed (recorded) to each of the films by the same method as that in the case of Example 3, the ratio of the mark forming area (S₂) relative to the laser irradiation area (S₂) was determined as an area ratio [(S₂/S₁) × 100] and this was used as an index of the recording performance. The evaluation standard for the area ratio was identical with that in Example 3. That is, it was evaluated in view of the area ratio as failure in a case where it was less than 20%, excellent in a case where it was from 20 to 90% (20% or more and 90% or less) and fair in a case where it exceeded 90% (allowable range though inferior to excellent).

For each of the Ag film and the Ag alloy films, after retaining them in an atmospheric air at a temperature of 80°C and at a humidity of 85%, the reflectivity (reflectivity at a wavelength of 405 nm) was measured and the lowering amount of the reflectivity at the wavelength of 405 nm before and after 95 hr's retention was determined.

The result is shown in Table 8. As apparent from Table 8, Ag-Sn(15 at%, 30 at%) alloy film, Ag-In(15 at%) alloy film, Ag-Nd(15 at%) alloy film, and Ag-Bi(15 at%) alloy film had extremely lower heat conductivity compared with that of the Ag film and had the melting temperature equal with or lower than that in the case of the Ag film and, accordingly, it can be seen that the heat conductivity can be decreased without increasing the melting temperature by the addition of Sn, In, Nd, or Bi to Ag. In a case where the addition amount (content) of the elements is 5 at% or more, good recording marks were formed and the recording performance was good. Ag-Sn(3.0 at%) alloy film had the area ratio [(S₂/S₁) × 100] as the index of the recording performance being evaluated as failure (less than 20%) and poor recording performance. In a case where the addition amount of Sn, In, Nd, or Bi was less than 30 at%, the effect of decreasing the heat conductivity was small and, on the other hand, in a case where it exceeded 30 at%, the melting point increased remarkably and the characteristics as the recording film could no more be obtained. In view of the above, it can be seen that the addition amount of Sn, In, Nd or Bi to Ag is, preferably, from 5 to 30 at %.

Further, as can be seen from Table 8, in Ag-Sn(15 at%)-Bi(0.01 at%, 2.0 at%) alloy film, the lowering amount of the reflectivity was small. As described above, by the addition of a small amount of Bi, lowering of the reflectivity after the wet heat test can be suppressed and the durability can also be improved. Compared with this alloy film, Ag-Sn(15 at%)-Bi(4.0 at%) alloy film showed large lowering amount of the reflectivity.

In a case of further incorporating one or more of Bi and Sb in a small amount to the Ag alloy containing one or more of Sn, In, and Nd totaling 5 to 30 at%, lowering of the reflectivity can be suppressed as described above when the content of one or more of Bi and Sb is defined as 0.01 to 2.0 at%. When it is less than 0.01 at%, it is difficult to obtain the effect of suppressing the lowering of the reflectivity and, when it exceeds 2.0%, the degree of lowering the reflectivity is increased rather.

**Table 1**

| Laser power (film surface) | Heat conductivity | Highest attainable temperature | Heat interference ratio |
|---|---|---|---|
| 10mW | 2.0 W/Kcm | 221°C | 0.8 |
| 10mW | 0.8 W/Kcm | 711°C | 0.5 |
| 10mW | 0.3 W/Kcm | 1075°C | 0.3 |
| 10mW | 0.1 W/Kcm | 1320°C | 0.2 |
| 10mW | 0.05 W/Kcm | 1530°C | 0.1 |

**Table 2**

| Laser power (film surface) | Light absorptivity | Highest attainable temperature |
|---|---|---|
| 10mW | 5% | 175°C |
| 10mW | 15% | 530°C |
| 10mW | 20% | 660°C |
| 10mW | 30% | 1075°C |
| 10mW | 50% | 1731°C |

**Table 3**

| No. | Heat conductivity [W/Kcm] | Composition | Light absorptivity [%] | Reflec tivity [%] | Melting point [°C] | Recording mark | Remark |
|---|---|---|---|---|---|---|---|
| 1 | 1.0 | Al-1.0Sn | 13.1 | 55.9 | 659 | Failure | not melted |
| 2 | 0.8 | Al-2.0Sn-0.5Nd | 15.8 | 45.0 | 658 | Good | |
| 3 | 0.3 | Al-2.0Sn-5.0Nd | 23.0 | 38.1 | 656 | Good | |
| 4 | 0.1 | Al-5.0Sn-10.0Nd | 41.0 | 30.1 | 641 | Good | |
| 5 | 0.05 | Al-10.0Sn-20.0Nd | 63.9 | 21.8 | 672 | Good | |

**Table 4**

| No. | Composition | Heat conductivity [W/Kcm] | Melting temperature [°C] | Absorptivity [%] | Reflectivity [%] | Judgement for recording mark | Corrosion resistance |
|---|---|---|---|---|---|---|---|
| 6 | Al | 1.8 | 660 | 11.5 | 61.8 | Failure | Failure |
| 7 | Al-2-0%Sn | 0.70 | 658 | 14.3 | 50.3 | Failure | Failure |
| 8 | Al-5.0%Sn | 0.64 | 635 | 31.5 | 36.8 | Good | Good |
| 9 | Al-30.0%Sn | 0.31 | 598 | 44.6 | 26.4 | Good | Good |
| I-1 | Al-10.0%Sn-2%ln | 0.48 | 605 | 38.2 | 37.0 | Good | Good |
| I-2 | Al-10.0%Sn-8%ln | 0.36 | 602 | 41.3 | 34.8 | Good | Good |
| I-3 | Al-10.0%Sn-10%In | 0.32 | 608 | 41.6 | 34.2 | Good | Good |
| I-4 | Al-10.0%Sn-12%In | 0.30 | 610 | 42.1 | 33.2 | Good | Failure |
| M-1 | Al-10.0%Sn-4%Mn | 0.41 | 603 | 38.9 | 41.5 | Good | Good |
| N-1 | Al-10.0%Sn-2%Ni | 0.46 | 608 | 32.1 | 46.6 | Good | Good |
| 10 | Al-60.0%Sn | 0.16 | 535 | 49.2 | 21.5 | Good | Good |
| 11 | Al-80.0%Sn | 0.12 | 485 | 55.6 | 19.3 | Fair | Good |
| 12 | Al-2.0%Mg | 0.85 | 654 | 13.2 | 43.1 | Failure | Failure |
| 13 | Al-5.0%Mg | 0.32 | 632 | 30.1 | 35.8 | Good | Good |
| 14 | Al-30.0%Mg | 0.16 | 521 | 45.2 | 31.9 | Good | Good |
| 15 | Al-60.0%Mg | 0.06 | 452 | 59.3 | 24.3 | Good | Good |
| 16 | Al-80.0%Mg | 0.05 | 548 | 68.7 | 20.9 | Fair | Good |
| 17 | Al-2.0%Zn | 0.76 | 660 | 13.1 | 53.2 | Failure | Failure |
| 18 | Al-5.0%Zn | 0.45 | 655 | 28.7 | 41.0 | Good | Good |
| 19 | Al-30.0%Zn | 0.16 | 612 | 35.6 | 32.1 | Good | Good |
| 20 | Al-60.0%Zn | 0.12 | 558 | 41.8 | 28.5 | Good | Good |
| 21 | Al-80.0%Zn | 0.10 | 521 | 51.9 | 16.3 | Fair | Good |

**Table 5**

| No. | Composition | Heat conductivity [W/Kcm] | Melting temperature [°C] | Absorptivity [%] | Reflectivity [%] | Judgement for recording mark |
|---|---|---|---|---|---|---|
| 22 | Al | 1.8 | 660 | 11.5 | 61.8 | Failure |
| 23 | Al-30.0%Sn | 0.31 | 598 | 44.6 | 26.4 | Good |
| 24 | Al-30.0%Sn-0.5%Nd | 0.30 | 597 | 45.1 | 26.0 | Good |
| 25 | Al-30.0%Sn-1.0%Nd | 0.28 | 596 | 45.8 | 25.5 | Good |
| 26 | Al-30.0%Sn-10.0%Nd | 0.12 | 610 | 51.9 | 23.1 | Good |
| 27 | Al-30.0%Sn-20.0%Nd | 0.08 | 656 | 58.1 | 21.2 | Good |
| 28 | Al-30.0%Sn-30.0%Nd | 0.07 | 810 | 65.9 | 15.8 | Failure |
| 29 | Al-30.0%Sn.10.0%Y | 0.13 | 618 | 53.7 | 24.7 | Good |

**Table 6**

| No. | Composition | Melting Temperature [°C] | Lowering amount of reflectivity [%] | Heat conduc tivity [W/Kcm] | Absorptivity [%] | Initial reflectivity [%] | Marking |
|---|---|---|---|---|---|---|---|
| 30 | Al | 660 | 126 | 1.8 | 11.5 | 61.8 | Failure |
| 31 | Al-30.0%Sn | 598 | 3.6 | 0.31 | 44.6 | 26.4 | Good |
| 32 | Al-30.0%Sn-5.0%Nd-0.5%Ta | 597 | 3.4 | 0.18 | 47.9 | 24.1 | Good |
| 33 | Al-30.0%Sn-5.0%Nd-1.0%Ta | 612 | 1.6 | 0.16 | 48.5 | 23.8 | Good |
| 34 | Al-30.0%Sn-5.0%Nd-2.0%Ta | 646 | 0.8 | 0.15 | 51.0 | 220 | Good |
| 35 | Al-30.0%Sn-5.0%Nd-15.0%Ta | 668 | 0.6 | 0.11 | 58.2 | 20.1 | Failure |
| 36 | Al.30.0%Sn-5.0%Nd-2.0%T | 632 | 1.3 | 0.17 | 48.9 | 23.2 | Good |
| 37 | Al-30.0%Sn-5.0%Nd-2.0%Cr | 618 | 1.7 | 0.16 | 48.3 | 23.5 | Good |

**Table 7**

| No. | Composition | Pit corrosion generation pontential [mV vs SCE] | Heat conductivity [W/Kcm] | Melting temperature [°C] | Absorptivity [%] | Reactivity [%] | Marking |
|---|---|---|---|---|---|---|---|
| 38 | Al | -820 | 1.8 | 660 | 11.5 | 61.8 | Failure |
| 39 | Al-30.0%Sn-2-0Nd-10Ta | -650 | 0.27 | 596 | 46.3 | 28.3 | Good |
| 40 | Al-30.0%Sn-20Nd-1.0Ta-0.5S | -648 | 0.27 | 596 | 46.5 | 28.1 | Good |
| 41 | Al-30, 0%Sn-2.0Nd-1.0Ta-1.0Si | -632 | 0.26 | 594 | 46.8 | 27.8 | Good |
| 42 | Al-30.0%Sn-2.0Nd-1.0Ta-5.0Si | -531 | 0.19 | 573 | 52.3 | 25.0 | Good |
| 43 | Al-30.0%Sn-2.0Nd-1.0Ta-15.0Si | -432 | 0.06 | 517 | 65.1 | 18.1 | Good |
| 44 | Al-30.0%Sn-2.0Nd.1.0Ta.15.0Ge | -468 | 0.08 | 505 | 59.3 | 28.5 | Good |

**Table 8**

| No. | Composition | Heat conductivity [W/Kcm] | Melting temperature [°C] | Lowering amount of reflectivity [%] | Initial absorptivity [%] | Reflectivity after 96 hr's retention [%] | Marking |
|---|---|---|---|---|---|---|---|
| 45 | Ag | 3.3 | 962 | 42% | 3.1 | 33.2 | Failure |
| 46 | Ag-3.0Sn | 1.1 | 961 | 3.4% | 7.2 | 31.8 | Failure |
| 47 | Ag-15Sn | 0.08 | 621 | 3.1% | 35.0 | 21.6 | Good |
| 48 | Ag-30Sn | 0.06 | 510 | 15.2% | 51.2 | 20.5 | Good |
| 49 | Ag-15ln | 0.09 | 796 | 2.8% | 27.7 | 27.6 | Good |
| 50 | Ag-15Nd | 0.08 | 806 | 4.2% | 31.9 | 29.1 | Good |
| 51 | Ag-15Bi | 0.07 | 732 | 5.1% | 35.8 | 21.6 | Good |
| 52 | Ag-15Sn-0,01Bi | 0.08 | 618 | 3.0% | 51.3 | 25.0 | Good |
| 54 | Ag-15Sn-20Bi | 0.08 | 620 | 1.8% | 48.2 | 23.1 | Good |
| 54 | Ag-15Sn-4.0Bi | 0.07 | 610 | 8.2% | 58.0 | 18.3 | Good |

Since the recording film according to the invention not only provides a good performance as the recording film by the laser heat melting recording system (sufficient recording is possible) but also is excellent in the productivity and excellent in the durability (recording retainability), it can be used suitably as the recording film for use in an optical information recording medium and is useful.

The foregoing invention has been described in terms of preferred embodiments. However, those skilled, in the art will recognize that many variations of such embodiments exist. Such variations are intended to be within the scope of the present invention and the appended claims.

## Claims

1. A sputtering target for forming a recording film for use in an optical information recording medium, comprising an Al alloy containing at least one of Sn, Zn, and Mg totaling 5.0 to 60 at%.

2. The sputtering target according to claim 1, wherein the Al alloy contains at least one of In, Mn and Ni totaling 2.0 to 10.0 at%.

3. The sputtering target according to claim 1 or 2, wherein the Al alloy contains at least one of Nd and Y totaling 1.0 to 20.0 at%.

4. The sputtering target according to any one of claims 1 to 3, wherein the Al alloy contains at least one of Cr, Ta, Ti, and Ni totaling 1.0 to 10.0 at%.

5. The sputtering target according to any one of claims 1 to 4, wherein the Al alloy contains at least one of Si and Ge totaling 1.0 to 15.0 at%.

6. A sputtering target for forming a recording film for use in an optical information recording medium comprising an Ag alloy containing at least one of Sn, In, and Nd totaling 5.0 to 30 at%.

7. A sputtering target for forming a recording film for use in an optical information recording medium comprising an Ag alloy containing Bi of 10 to 60 at%.

8. The sputtering target according to claim 6 or 7, wherein the Ag alloy contains Sb of 0.01 to 2.0 at%.

9. The sputtering target according to claim 6, wherein the Ag alloy contains Bi of 0.05 to 5 at%.
